# EUROPÄISCHE PATENTANMELDUNG

(11) **EP 4 492 631 A2**
(43) Veröffentlichungstag der Anmeldung: **15.01.2025**
(21) Anmeldenummer: 24186700.1
(22) Anmeldetag: 05.07.2024
(51) Int. Cl.: H02J 13/00, G01R 19/25

(54) **VERFAHREN ZUR DEZENTRALEN BEWERTUNG DER VERSORGUNGSSICHERHEIT, SYSTEM UND COMPUTERPROGRAMMPRODUKT**

(30) Priorität: 14.07.2023 DE 102023118775
(71) Anmelder: LEW Verteilnetz GmbH, 86150 Augsburg (DE)
(72) Erfinder: Baumgartner, Sonja, Augsburg (DE); Barta, Veronika, München (DE); Dulisch, Armin, München (DE); Uhrig, Prof. Dr.-Ing Stephanie, München (DE)
(74) Vertreter: Bals & Vogel Patentanwälte PartGmbB

(57) **Zusammenfassung**

Die Erfindung betrifft ein Verfahren (100) zur dezentralen Bewertung der Versorgungssicherheit eines Stromnetzes (200), umfassend:
- Erfassen (110) zumindest eines Referenzmesswertes (11) in einem Zeitfenster (10) an einem Netzbereich (210),
- Ermitteln (120) zumindest eines Normalbereiches (12) und eines Gefährdungsbereiches (13), wobei der Normalbereich (12) und der Gefährdungsbereich (13) durch den zumindest einen Referenzmesswert (11) im Zeitfenster (10) zumindest teilweise bestimmt sind,
- Messen (130) eines aktuellen Messwertes (15) am Netzbereich (210), und
- Bewerten (140) der Versorgungssicherheit des Netzbereiches (210) auf Basis des aktuellen Messwertes (15) gemäß des ermittelten Normalbereiches (12) und des Gefährdungsbereiches (13) als normal oder gefährdet,
wobei zumindest die Erfassung (110), das Ermitteln (120), das Messen (130) und die Bewertung (140) am Netzbereich (210) durchgeführt werden. Ferner betrifft die Erfindung ein System (400) und ein Computerprogrammprodukt.

## Beschreibung

Die Erfindung betrifft ein Verfahren zur dezentralen Bewertung der Versorgungssicherheit, ein System sowie ein Computerprogrammprodukt.

Die Zunahme erneuerbarer Energien im Stromnetz bringt Herausforderungen mit sich, welche eine Anpassung und Weiterentwicklung des Netzes sowie der Koordination von Erzeugern und Verbrauchen erfordern.

Die schwankende Einspeisung von Wind- und Solarenergie, die je nach Wetterlage und Tageszeit variiert und nicht immer dem Verbrauchsbedarf entspricht, erhöht den Regelungsbedarf grundsätzlich. Dabei wird Wind- und Solarenergie zunehmend dezentral eingespeist.

Gleichzeitig steigt beispielsweise durch Elektromobilität, Digitalisierung und Wärmeerzeugung mit Strom die Nachfrage nach Strom insgesamt.

Folglich besteht ein Bedarf an einer Lösung, die es ermöglicht, das Verteilnetz an die schwankende Einspeisung von erneuerbaren Energien oder schwankenden Lasten anzupassen. Die herkömmlichen Methoden zur Netzregelung sind insbesondere nicht in der Lage, die kurzfristigen und lokal unterschiedlichen Änderungen des Betriebszustands zu berücksichtigen, die durch Windkraft- und Photovoltaikanlagen verursacht werden. Diese Anlagen sind oft in niedrigen oder mittleren Spannungsebenen eingebunden und erzeugen je nach Wetterlage eine hohe oder geringe Einspeisung. Dies kann prinzipiell zu einer Instabilität des Netzes und einer Beeinträchtigung der Versorgungsqualität führen.

Es ist daher eine Aufgabe der vorliegenden Erfindung, wenigstens einen der voranstehend beschriebenen Nachteile zumindest teilweise zu überwinden. Insbesondere ist es Aufgabe der Erfindung ein Verfahren zur dezentralen Bewertung der Versorgungssicherheit eines Stromnetzes, ein System sowie ein Computerprogrammprodukt bereitzustellen, welches eine kostengünstig und schnell realisierbare Möglichkeit der Sicherstellung der Versorgungssicherheit im Stromnetz gestattet.

Die voranstehende Aufgabe wird gelöst durch ein Verfahren mit den Merkmalen des unabhängigen Patentanspruchs 1, durch ein System mit den Merkmalen des unabhängigen Patentanspruchs 14 sowie durch ein Computerprogrammprodukt mit den Merkmalen des unabhängigen Patentanspruchs 15. Weitere Merkmale und Details der Erfindung ergeben sich aus den Unteransprüchen, der Beschreibung und den Zeichnungen. Dabei gelten Merkmale und Details, die im Zusammenhang mit dem erfindungsgemäßen Verfahren beschrieben sind, selbstverständlich auch im Zusammenhang mit dem erfindungsgemäßen System und/oder im Zusammenhang mit dem erfindungsgemäßen Computerprogrammprodukt und jeweils umgekehrt, so dass bezüglich der Offenbarung zu den einzelnen Erfindungsaspekten stets wechselseitig Bezug genommen wird bzw. werden kann.

Erfindungsgemäß vorgesehen ist ein Verfahren zur dezentralen Bewertung der Versorgungssicherheit eines Netzbereiches eines Stromnetzes, umfassend:
- Erfassen zumindest eines Referenzmesswertes in einem Zeitfenster am Netzbereich, insbesondere durch eine Messeinheit,
- Ermitteln zumindest eines Normalbereiches und eines Gefährdungsbereiches, wobei der Normalbereich und der Gefährdungsbereich durch den zumindest einen Referenzmesswert im Zeitfenster zumindest teilweise bestimmt sind, insbesondere durch eine Steuereinheit,
- Messen eines aktuellen Messwertes am Netzbereich, insbesondere durch eine Messeinheit, und
- Bewerten der Versorgungssicherheit des Netzbereiches auf Basis des aktuellen Messwertes gemäß des ermittelten Normalbereiches und des Gefährdungsbereiches als normal oder gefährdet, insbesondere durch eine Steuereinheit,
wobei zumindest die Erfassung, das Ermitteln, das Messen und die Bewertung am Netzbereich durchgeführt werden.

Mit anderen Worten ist eine Methode zur Einschätzung eines Zustandes eines Teils eines Stromnetzes vorgesehen, bei der zumindest ein Initialwert gemessen wird, der innerhalb eines vorgegebenen Zeitraumes liegt. Dieser Initialwert bestimmt Grenzwerte für einen Normalzustand, in dem das Stromnetz regulär funktioniert, und einen Bedrohungszustand, in dem zu befürchten ist, dass das Stromnetz bei weiterer Verschlechterung nicht regulär funktioniert. Durch die Aufnahme zumindest eines aktuellen Messwertes kann nach Maßgabe der Grenzwerte bestimmt werden, ob das Stromnetz gerade im Normal- oder im Bedrohungszustand operiert. Dabei werden die genannten Schritte dezentral direkt an dem Teil des Stromnetzes durchgeführt, an dem auch der Initialwert gemessen wird.

Das Verfahren kann als computerimplementiertes Verfahren ausgeführt sein.

Die Verfahrensschritte können zumindest teilweise gleichzeitig und/oder zeitlich nacheinander ablaufen, wobei die Reihenfolge der Verfahrensschritte nicht durch die angegebene Reihenfolge begrenzt ist, sodass einzelne Schritte in unterschiedlicher Reihenfolge durchführbar sind. Ferner können einzelne oder sämtliche Schritte wiederholt durchgeführt werden.

Unter einer dezentralen Bewertung kann eine Bewertung verstanden werden, welche an einem Ort stattfindet und/oder sich auf einen Teil des Stromnetzes bezieht, welcher einem Letztverbraucher zugänglich ist. Analog zur dezentralen Stromerzeugung, bei der die elektrische Energie nicht in großen Kraftwerken erzeugt und über weite Strecken transportiert wird, kann unter der dezentralen Bewertung verstanden werden, dass die Bewertung eines lokalen Bereichs des Netzes vor Ort, insbesondere nicht in einem Kraftwerk und/oder in einem zentralen Rechenzentrum, durchgeführt wird. Anders ausgedrückt kann die dezentrale Bewertung zumindest ohne Berücksichtigung von Daten anderer Messstellen, der Kenntnis der Netzstruktur des Stromnetzes oder angeschlossener Verbraucher und Einspeiseanlagen erfolgen.

Die Versorgungssicherheit kann sich zumindest auf die Zuverlässigkeit, die Stabilität und die Qualität des angebotenen Stroms beziehen. Es kann vorgesehen sein, dass die Versorgungssicherheit im Wesentlichen der Einhaltung der in der DIN EN 50160 ("Characteristics of the voltage in public electricity supply grids", insbesondere in der Version von November 2020 oder jünger) vorgegebenen Kriterien entspricht.

Unter einem Netzbereich eines Stromnetzes kann ein Teil des Stromnetzes verstanden werden, welcher substantiell kleiner ist als das Gesamtstromnetz. Konkrete Ausgestaltungen des Netzbereiches werden im Zusammenhang mit den Unteransprüchen beschrieben.

Das Erfassen kann einer Messung und/oder einem Abfragen eines des Referenzmesswertes entsprechen. Dabei wird der Referenzmesswert an dem zu bewertenden Netzbereich erfasst. Der Referenzmesswert kann spezifisch für den Netzbereich sein. Mit anderen Worten wird der Referenzmesswert durch den physischen Zustand des Netzbereichs bestimmt. Wenn der Netzbereich beispielsweise ein Heimnetz eines Letztverbrauchers ist, so wird der Referenzmesswert direkt in der Immobilie des Letztverbrauchers gemessen.

Der zumindest eine Referenzmesswert kann als Basis für die Ermittlung eines Normalbereiches oder eines Gefährdungsbereiches aufgefasst werden. Mit anderen Worten dient der Referenzmesswert dazu, Grenzen für einen Normalbetrieb festzulegen. Es kann vorgesehen sein, dass mehr als ein Referenzmesswert erfasst wird. Insbesondere kann vorgesehen sein, dass innerhalb des Zeitfensters eine Vielzahl von Referenzmesswerten erfasst wird. Ebenfalls ist denkbar, dass die Vielzahl an Referenzmesswerten als Funktion der Zeit innerhalb des Zeitfensters erfolgt, sodass eine Referenzmesswertgröße als Funktion der Zeit erfasst wird.

Ferner kann vorgesehen sein, dass in Ergänzung zum Referenzmesswert Referenzumgebungsmesswerte aufgenommen werden, insbesondere die Sonneneinstrahlung, die Windstärke oder die Außentemperatur.

Unter einem Zeitfenster kann eine zeitliche Dauer verstanden werden. Innerhalb des Zeitfensters muss der zumindest ein Referenzmesswert gemessen werden. Es kann bei dem Verfahren vorgesehen sein, dass das Festlegen eines Zeitfensters vorgesehen ist. Das Zeitfenster kann vor oder unmittelbar mit der Messung des aktuellen Messwertes enden.

Das Ermitteln zumindest eines Normalbereiches und eines Gefährdungsbereiches kann als eine Berechnung aufgefasst werden, bei der auf Basis des Referenzmesswertes Grenzwerte für Beginn und Ende des Normal- und Gefährdungsbereiches ermittelt werden. Es kann vorgesehen sein, dass die Berechnung auf einem maschinellen Lernalgorithmus basiert. Der maschinelle Lernalgorithmus kann mit historischen Messdaten trainiert sein. Alternativ oder in Ergänzung kann vorgesehen sein, dass der Algorithmus, insbesondere in Anpassung an den zu bewertenden Netzbereich, vorgegeben wird. Dies kann durch den Netzbetreiber erfolgen.

Der Normalbereich und der Gefährdungsbereich können entweder ganz oder zumindest teilweise bestimmt werden durch den Referenzmesswert. Wenn die Bereiche vollständig durch den Referenzmesswert bestimmt sind, sind für den Algorithmus, der die Bereiche bestimmt, keine weiteren Eingabegrößen notwendig. Alternativ kann auch vorgesehen sein, dass der Algorithmus weitere Eingangsgrößen, insbesondere Referenzumgebungsmesswerte, mit in die Bestimmung von Normalbereich und den Gefährdungsbereich aufnimmt.

Das Messen eines aktuellen Messwertes am Netzbereich kann einer Messung und/oder einem Abfragen eines Messwertes, insbesondere durch eine Messeinheit, entsprechen. Der Messwert kann spezifisch für den Netzbereich sein. Mit anderen Worten wird der Messwert durch den physischen Zustand des Netzbereichs bestimmt.

Unter einem Bewerten der Versorgungssicherheit kann das Einteilen in einen von zumindest zwei Zuständen verstanden werden. Entweder der aktuelle Messwert fällt in einen Bereich, der mit dem Zustand "normal" assoziiert ist, oder der Messwert fällt in einen Bereich, der mit dem Zustand "gefährdet" assoziiert ist. Bei der Bewertung kann es sich um einen einfachen Größenvergleich handeln, beispielsweise ob eine Spannung oberhalb oder unterhalb eines Grenzwertes liegt. Mit anderen Worten kann die Bewertung ganz oder zumindest teilweise von dem Messwert und den Bereichen bestimmt sein. Es kann ebenfalls vorgesehen sein, dass in die Bewertung noch weitere Eingangsgrößen, insbesondere aktuelle Umgebungsmesswerte, einfließen. Hierzu kann vorgesehen sein, dass in Ergänzung zum aktuellen Messwert aktuelle Umgebungsmesswerte aufgenommen werden, insbesondere die Sonneneinstrahlung, die Windstärke oder die Außentemperatur.

Vorteilhaft kann vorgesehen sein, dass bei der Ermittlung und Bewertung diejenigen Referenzmesswerte verwendet werden, welche bei Referenzumgebungsmesswerten aufgenommen wurden, die im Wesentlichen oder vollständig den Umgebungsmesswerten entsprechen. Hierdurch kann eine verbesserte Bewertungsgenauigkeit erreicht werden.

Gemäß der Erfindung ist vorgesehen, dass zumindest die Erfassung, das Ermitteln, das Messen und die Bewertung am Netzbereich durchgeführt werden. Mit anderen Worten können die Schritte des Verfahrens, insbesondere sämtliche Schritte des Verfahrens, an dem Ort durchgeführt werden, welche dem zu bewertenden Netzbereich entspricht. "An diesem Ort" kann dabei insbesondere in Abgrenzung zu "zentral", verstanden werden.

Insgesamt wird durch das erfindungsgemäße Verfahren der Vorteil erreicht, dass eine kostengünstig und schnell realisierbare Möglichkeit der Wahrung der Versorgungssicherheit im Stromnetz gestattet wird. Das Erfassen zumindest eines Referenzmesswertes in einem Zeitfenster am Netzbereich, bietet den Vorteil, dass lokal am Netzbereich eine für diese spezifische Ausgangsgröße messbar ist, die eine Beurteilung eines zukünftigen Zustandes des Netzbereiches ermöglicht. Das Ermitteln zumindest eines Normalbereiches und eines Gefährdungsbereiches, wobei der Normalbereich und der Gefährdungsbereich durch den zumindest einen Referenzmesswert im Zeitfenster zumindest teilweise bestimmt sind, ermöglicht eine einfache Einteilung des Zustandes des Netzbereiches, auf dessen Basis eine schnelle und effiziente Bewertung erfolgen kann. Durch die Messung eines aktuellen Messwertes am Netzbereich wird eine für den aktuellen Zustand des Netzbereiches maßgebliche Größe ermittelt. Das Bewerten der Versorgungssicherheit des Netzbereiches auf Basis des aktuellen Messwertes gemäß des ermittelten Normalbereiches und des Gefährdungsbereiches als normal oder gefährdet, bietet den Vorteil, dass schnell zwischen einem Normalzustand, bei dem ein Normalbetrieb fortgeführt werden kann, und einem Gefährdungszustand, bei dem die Versorgungssicherheit gefährdet ist, unterschieden werden kann. Das Ergebnis dieser Bewertung ist eindeutig, sodass die Versorgungssicherheit besonders zuverlässig gewährleistet werden kann. Darüber hinaus bietet die Tatsache, dass die Erfassung, das Ermitteln, das Messen und die Bewertung am Netzbereich durchgeführt wird den Vorteil, dass das gesamte Verfahren dezentral abläuft und ohne Berücksichtigung von Daten anderer Messstellen, der Kenntnis der Netzstruktur oder angeschlossener Verbraucher und Einspeiseanlagen erfolgen kann. Zum einen würde eine zentralisierte Bewertung den Implementierungsaufwand erhöhen. Zum anderen kann durch den dezentralen Ansatz die Sicherheit des Stromnetzes erhöht werden, da bereits die Netzbereiche für sich genommen eine Versorgungssicherheit zumindest teilweise gewährleisten können.

Im Rahmen der Erfindung kann es von Vorteil sein, dass der Netzbereich zumindest ausgeführt ist als ein Letztverbraucherzugangspunkt, ein Letztverbrauchernetz oder ein Inselnetz. Die genannten Netzbereiche bieten den Vorteil, dass diese gegenüber einem Stromnetz relativ klein und/oder autark von diesem ausgeführt seien können.

Ein Letztverbraucher im Zusammenhang mit der Erfindung kann als eine Person, ein Haushalt, ein Unternehmen oder eine Organisation verstanden werden, die elektrische Energie aus dem Stromnetz bezieht und für den Endverbrauch nutzt. Letztverbraucher können die letzten Glieder in der Kette der Stromversorgung sein und in direkter Verbindung mit dem Stromnetz stehen. Unter einem Letztverbraucherzugangspunkt wird entsprechend die Abnahmestelle des Letztverbrauchers und die Einrichtungen verstanden, welche dazu ausgeführt sind, für den Letztverbraucher Strom zu produzieren, zu verbrauchen und für beide Vorgänge notwendige Verbindungen und Regelungen bereitstellen. Beispielsweise kann der Letztverbraucherzugangspunkt als Ladestation für Elektrofahrzeuge oder als Haushaltsanschluss ausgeführt sein.

Ein Letztverbrauchernetz kann gegenüber dem Letztverbraucherzugangspunkt als Zusammenschluss von zumindest zwei Letztverbraucherzugangspunkten aufgefasst werden. Beispielsweise kann es sich dabei um einen Hausanschluss für zumindest zwei Haushalte handeln.

Ein Inselnetz kann als zumindest teilweise autark arbeitendes Netz aufgefasst werden. Im Gegensatz zu einem Verbundnetz, das aus einem komplexen Netzwerk von Kraftwerken, Übertragungs- und Verteilungsleitungen besteht, kann ein Inselnetz normalerweise kleiner ausgeführt sein und eine begrenzte geografische Region bedient. Es kann beispielsweise auf abgelegenen Inseln, in ländlichen Gebieten oder in Industrieanlagen eingesetzt werden, die nicht an ein größeres Stromnetz angeschlossen sind.

Im Rahmen der Erfindung ist es denkbar, dass der aktuelle Messwert als weiterer Referenzmesswert dient, welcher bei einem zukünftigen Ermitteln den Normalbereich und den Gefährdungsbereich zumindest teilweise bestimmt. Anders ausgedrückt kann der aktuelle Messwert sogleich als Referenzmesswert für die zukünftige Bestimmung der Bereiche dienen. Dadurch wird der Vorteil erreicht, dass weniger Messungen insgesamt notwendig sind, als wenn der aktuelle Messwert für die Messung des Referenzmesswertes verworfen wird.

Es kann im Rahmen der Erfindung vorgesehen sein, dass ein Festlegen eines späteren Zeitfensters vorgesehen ist, wobei das spätere Zeitfenster zumindest nach dem Zeitfenster oder dem Zeitpunkt des Messens liegt, wobei insbesondere das spätere Zeitfenster bei Wiederholung der Verfahrensschritte als Zeitfenster ausgeführt ist. Anders ausgedrückt kann das Verfahren als weiteren Schritt vorsehen, dass für eine Wiederholung des Ablaufes ein neues Zeitfenster geplant wird. Dadurch wird der Vorteil erreicht, dass das Verfahren in einer Schleife ausführbar ist, sodass dauerhaft eine Bewertung des Zustandes des Netzbereiches mit aktuellen Referenzwerden durchgeführt werden kann.

Es ist ferner denkbar, dass zumindest der Referenzmesswert oder der aktuelle Messwert an einer Phase oder an zwei Phasen oder an drei Phasen des Netzbereiches erfolgt. Durch die Messung von zwei oder mehr Phasen kann eine besonders hohe Genauigkeit erreicht werden.

Es kann vorgesehen sein, dass ein Vergleich der Messung auf zumindest zwei Phasen bei der Ermittlung der Bereiche und/oder beim Bewerten des Netzbereiches einbezogen wird. Dies bietet den Vorteil, dass der Zustand des Netzbereiches genauer und zuverlässiger bestimmt werden kann.

Auch ist es denkbar, dass zumindest der Referenzmesswert oder der aktuelle Messwert zumindest als eine Spannung, ein Strom, eine Leistung oder eine Frequenz ausgeführt ist. Die genannten Größen lassen sich besonders einfach und kostengünstig messen, sodass das Verfahren insgesamt kostengünstig und effizient durchführbar ist. Die Frequenzmessung bietet besonders dann einen speziellen Vorteil, wenn der Netzbereich als Inselnetz ausgebildet ist. In Inselnetzen ist die Frequenz oftmals ein besserer Indikator für die Qualität des Netzes als beispielsweise der absolute Spannungswert, da diese durch das relativ kleine Netz nicht so gut ausgeglichen werden kann und empfänglicher für Störungen ist.

Im Rahmen der Erfindung ist es optional möglich, dass der Gefährdungsbereich einen unteren Gefährdungsbereich, welcher unterhalb des Normalbereiches liegt, und einen oberen Gefährdungsbereich, welcher oberhalb des Normalbereiches liegt, umfasst. Anders ausgedrückt kann der Normalbereich eine obere und untere Schranke aufweisen, wobei der Gefährdungsbereich außerhalb der beiden Schranken liegt. Dies bietet den Vorteil, dass bei einfachen Vergleichen, z. B. bei der Abweichung einer Spannung von einem oberen und/oder unteren Grenzwert, besonders einfach bestimmt werden kann, ob der Gefährdungsbereich erreicht wurde.

Ferner kann es im Rahmen der Erfindung vorgesehen sein, dass das Ermitteln einen kritischen Bereich umfasst, der durch den zumindest einen Referenzmesswert im Zeitfenster zumindest teilweise bestimmt ist, wobei der kritische Bereich ein größeres Gefährdungspotential aufweist als der Gefährdungsbereich. Mit anderen Worten kann vorgesehen sein, dass neben dem Normal- und Gefährdungsbereich noch zumindest ein weiterer Bereich vorgesehen ist, der einer größeren Dringlichkeit entspricht. Es kann ferner auch vorgesehen sein, dass noch weitere Bereiche mit einer feineren Abstufung vorgesehen sind. Durch die Festlegung von mehr Bereichen wird die Flexibilität bei der Bewertung des Netzbereichs erhöht, sodass feiner abgestimmte Maßnahmen getroffen oder vorbereitet werden können.

In Bezug auf die vorliegende Erfindung ist es vorstellbar, dass bei dem Bewerten der Versorgungssicherheit des Netzbereiches neben dem aktuellen Messwert zumindest eine weitere Information verarbeitet wird, welche für den Netzbereich spezifisch und insbesondere vorgegeben ist. Es kann sich bei der weiteren Information beispielsweise um die Information über eine Struktur des Netzbereiches handeln (z.B. wie viele Verbraucher und Erzeuger im Netzbereich vorhanden und wie diese miteinander verbunden sind oder wie z.B. Messwerte an einem zugehörigen Transformatorausgang ausgebildet sind). Ferner kann die weitere Information auch als eine Umgebungsinformation ausgeführt sein, welche insbesondere Messwerte für die aktuelle Sonneneinstrahlung, die Windstärke oder die Außentemperatur umfassen kann. Hierdurch wird der Vorteil erreicht, dass die Bewertung genauer an die aktuelle Situation abgestimmt werden kann. Sind beispielsweise besonders kritische Verbraucher (etwa medizinische Geräte) an den Netzbereich angeschlossen, muss die Versorgungssicherheit ggf. kritischer bewertet werden als wenn ausschließlich Haushaltsgeräte an den Netzbereich angeschlossen sind.

Ferner ist es vorstellbar, dass das Zeitfenster eine vorgegebene Größe hat, wobei die vorgegebene Größe insbesondere zumindest eine Minute, eine Stunde oder einen Tag beträgt. Vorteilhaft hat das Zeitfenster eine Größe, in der mehr als ein Messwert erfasst werden kann und welche eine bestimmte Situation im Netzbereich (beispielsweise einen typischen Montagmorgen) abbildet. Dadurch wird der Vorteil erreicht, dass die Bewertung des Netzbereiches besonders robust gegenüber kurzfristigen Störungen und Abweichungen wird.

Im Rahmen der Erfindung kann es von Vorteil sein, dass ein Aufbereiten des zumindest einen Referenzmesswertes und/oder eines Messwertes vorgesehen ist, wobei insbesondere das Aufbereiten zumindest eine Mittelwertbildung, eine Glättung, ein Filtern oder eine Fast Fourier Transformation umfasst. Durch die Aufbereitung kann zum einen vermieden werden, dass Ausreißer die Bestimmung der Bereiche oder der Bewertung negativ beeinflussen und die Genauigkeit verschlechtern. Zum anderen kann durch die Aufbereitung, beispielsweise durch die Fast Fourier Transformation (FFT), eine Zusatzinformation ermittelt werden, wodurch die Aussagekraft der Bereiche erhöht werden kann.

Im Rahmen der Erfindung ist es denkbar, dass das Zeitfenster einen festgelegten zeitlichen Abstand hat, welcher insbesondere zumindest größer oder gleich einer Minute, einer Stunde, einer Woche oder einem Jahr ist. Durch die zeitlichen Abstände können bestimmte Situationen im Netzbereich abgebildet werden. Besonders interessant sind Abstände, bei denen eine regelmäßige Ähnlichkeit des Zustandes des Netzbereiches erwartet wird. Beispielsweise kann bei dem gleichen Tag im Vorjahr eine ähnlich starke Sonneneinstrahlung oder Windstärke erwartet werden, sodass die Produktion von erneuerbaren Energien ähnlich ausfallen dürfe. Auch tageweise können sich Regelmäßigkeiten ergeben, beispielsweise werden unter der Woche ggf. früher als am Wochenende Verbraucher eingeschaltet, wenn Personen, die auf den Netzbereich zugreifen, an diesen Tagen arbeiten.

Gemäß einem weiteren Aspekt der Erfindung ist ein Verfahren zum dezentralen Betrieb eines Netzbereiches eines Stromnetzes, umfassend ein Verfahren nach einem der vorhergehenden Ansprüche, wobei zumindest wenn die Versorgungssicherheit des Netzbereiches als gefährdet bewertet wird, als Reaktion auf die Bewertung das Durchführen zumindest einer Maßnahme vorgesehen ist, welche dazu ausgeführt ist, die Versorgungssicherheit des Netzbereiches zu verbessern, vorgesehen.

Der Schritt, dass zumindest wenn die Versorgungssicherheit des Netzbereiches als gefährdet bewertet wird, als Reaktion auf die Bewertung das Durchführen zumindest einer Maßnahme vorgesehen ist, welche dazu ausgeführt ist, die Versorgungssicherheit des Netzbereiches zu verbessern, kann ebenfalls Teil des Verfahrens nach einem der Ansprüche 1 bis 12 sein.

Maßnahmen zur Verbesserung der Versorgungssicherheit kann insbesondere die Vorbereitung auf ein Abschalten und/oder ein Abschalten von Verbrauchern und/oder Stromerzeugern sein. Ferner kann vorgesehen sein, dass eine Meldung, insbesondere an den Netzbetreiber, ausgegeben wird, damit im restlichen Stromnetz Maßnahmen ergriffen werden können, um die Versorgungssicherheit zu gewährleisten.

Insgesamt wird so der dezentrale Betrieb eines Netzbereiches und auch des Stromnetzes insgesamt in Bezug auf die Versorgungssicherheit verbessert.

Damit bringt ein erfindungsgemäßes Verfahren zum dezentralen Betrieb eines Netzbereiches eines Stromnetzes die gleichen Vorteile mit sich, wie sie ausführlich mit Bezug auf das erfindungsgemäße Verfahren zur dezentralen Bewertung der Versorgungssicherheit eines Netzbereiches eines Stromnetzes beschrieben worden sind.

Die obenstehende Aufgabe wird ferner gelöst durch ein erfindungsgemäßes System, insbesondere ausgeführt zur Durchführung eines erfindungsgemäßen Verfahrens nach einem der Ansprüche 1 bis 12 und/oder eines Verfahrens nach Anspruch 12, zur dezentralen Bewertung der Versorgungssicherheit eines Stromnetzes und/oder zum dezentralen Betrieb eines Netzbereiches, aufweisend eine Messeinheit, welche dazu ausgeführt ist,
- zumindest einen Referenzmesswert in einem Zeitfenster an dem Netzbereich zu erfassen, und
- einen aktuellen Messwert am Netzbereich zu messen, sowie
eine Steuereinheit, welche dazu ausgeführt ist,
- zumindest einen Normalbereich und einen Gefährdungsbereich zu ermitteln, wobei der Normalbereich und der Gefährdungsbereich durch den zumindest einen Referenzmesswert im Zeitfenster zumindest teilweise bestimmt sind, und
- die Versorgungssicherheit des Netzbereiches auf Basis des aktuellen Messwertes gemäß des ermittelten Normalbereiches und des Gefährdungsbereiches als normal oder gefährdet zu bewerten,
wobei zumindest die Erfassung, das Ermitteln, das Messen und die Bewertung am Netzbereich durchgeführt werden.

Damit bringt ein erfindungsgemäßes System die gleichen Vorteile mit sich, wie sie ausführlich mit Bezug auf das erfindungsgemäße Verfahren zur dezentralen Bewertung der Versorgungssicherheit eines Netzbereiches eines Stromnetzes und/oder dem erfindungsgemäßen Verfahren zum dezentralen Betrieb eines Netzbereiches beschrieben worden sind.

Die obenstehende Aufgabe wird ferner gelöst durch ein erfindungsgemäßes Computerprogrammprodukt, umfassend Befehle, die bei der Ausführung des Programms durch einen Computer, insbesondere durch eine Steuereinheit eines Systems nach Anspruch 14, diesen veranlassen, ein Verfahren nach einem der Ansprüche 1 bis 12 und/oder ein Verfahren nach Anspruch 12 auszuführen.

Damit bringt ein erfindungsgemäßes Computerprogrammprodukt die gleichen Vorteile mit sich, wie sie ausführlich mit Bezug auf das erfindungsgemäße Verfahren zur dezentralen Bewertung der Versorgungssicherheit eines Netzbereiches eines Stromnetzes und/oder dem erfindungsgemäßen Verfahren zum dezentralen Betrieb eines Netzbereiches und/oder dem erfindungsgemäßen System beschrieben worden sind.

Weitere Vorteile, Merkmale und Einzelheiten der Erfindung ergeben sich aus der nachfolgenden Beschreibung, in der unter Bezugnahme auf die Zeichnungen mehrere Ausführungsbeispiele der Erfindung im Einzelnen beschrieben sind. Dabei können die in den Ansprüchen und in der Beschreibung erwähnten Merkmale jeweils einzeln für sich oder in beliebiger Kombination erfindungswesentlich sein. Dabei ist die Erfindung in den folgenden Figuren gezeigt:
- Figur 1:: ein erfindungsgemäßes Verfahren zur dezentralen Bewertung der Versorgungssicherheit eines Netzbereiches sowie ein erfindungsgemäßes Verfahren zum dezentralen Betrieb eines Netzbereiches in einer schematischen Übersicht,
- Figur 2:: ein erfindungsgemäßes System in einer schematischen Übersicht, und
- Figur 3:: ein Beispieldiagramm, in dem unter anderem Referenzmesswerte, Messwerte, das Zeitfenster und Bereiche veranschaulicht werden.

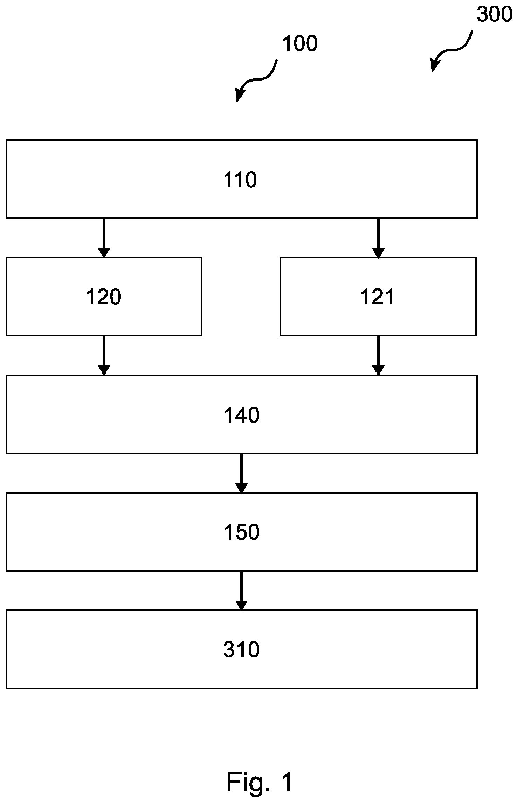

In der Figur 1 ist ein erfindungsgemäßes Verfahren 100 zur dezentralen Bewertung einer Versorgungssicherheit eines Netzbereiches 210 eines Stromnetzes 200 dargestellt. Das Verfahren 100 umfasst erfindungsgemäß
- ein Erfassen 110 zumindest eines Referenzmesswertes 11 in einem Zeitfenster 10 an dem Netzbereich 210,
- ein Ermitteln 120 zumindest eines Normalbereiches 12 und eines Gefährdungsbereiches 13, wobei der Normalbereich 12 und der Gefährdungsbereich 13 durch den zumindest einen Referenzmesswert 11 im Zeitfenster 10 zumindest teilweise bestimmt sind,
- ein Messen 130 eines aktuellen Messwertes 15 am Netzbereich 210, und
- ein Bewerten 140 der Versorgungssicherheit des Netzbereiches 210 auf Basis des aktuellen Messwertes 15 gemäß des ermittelten Normalbereiches 12 und des Gefährdungsbereiches 13 als normal oder gefährdet.
Dabei wird zumindest die Erfassung 110, das Ermitteln 120, das Messen 130 und die Bewertung 140 am Netzbereich 210 durchgeführt.

Insgesamt wird durch das erfindungsgemäße Verfahren 100 der Vorteil erreicht, dass eine kostengünstig und schnell realisierbare Möglichkeit der Sicherstellung der Versorgungssicherheit im Stromnetz 200 gestattet wird. Das Erfassen 110 zumindest eines Referenzmesswertes 11 in einem Zeitfenster 10 am Netzbereich 210, bietet den Vorteil, dass lokal am Netzbereich 210 eine für diese spezifische Ausgangsgröße messbar ist, die eine Beurteilung eines zukünftigen Zustandes des Netzbereiches 210 ermöglicht. Das Ermitteln 120 zumindest eines Normalbereiches 12 und eines Gefährdungsbereiches 13, wobei der Normalbereich 12 und der Gefährdungsbereich 13 durch den zumindest einen Referenzmesswert 11 im Zeitfenster 10 zumindest teilweise bestimmt sind, ermöglicht eine einfache Einteilung des Zustandes des Netzbereiches 210, auf dessen Basis eine schnelle und effiziente Bewertung erfolgen kann. Durch die Messung eines aktuellen Messwertes 15 am Netzbereich 210 wird eine für den aktuellen Zustand des Netzbereiches 210 maßgebliche Größe ermittelt. Das Bewerten 140 der Versorgungssicherheit des Netzbereiches 210 auf Basis des aktuellen Messwertes 15 gemäß des ermittelten Normalbereiches 12 und des Gefährdungsbereiches 13 als normal oder gefährdet, bietet den Vorteil, dass schnell zwischen einem Normalzustand, bei dem ein Normalbetrieb fortgeführt werden kann, und einem Gefährdungszustand, bei dem die Versorgungssicherheit gefährdet ist, unterschieden werden kann. Das Ergebnis dieser Bewertung ist eindeutig, sodass die Versorgungssicherheit besonders sicher gewährleistet werden kann. Darüber hinaus bietet die Tatsache, dass die Erfassung, das Ermitteln 120, das Messen 130 und die Bewertung am Netzbereich 210 durchgeführt werden den Vorteil, dass das gesamte Verfahren 100 dezentral abläuft und ohne Berücksichtigung von Daten anderer Messstellen, der Kenntnis der Netzstruktur oder angeschlossener Verbraucher und Einspeiseanlagen erfolgen kann. Zum einen würde eine zentralisierte Bewertung den Implementierungsaufwand erhöhen. Zum anderen kann durch den dezentralen Ansatz die Sicherheit des Stromnetzes 200 erhöht werden, da bereits die Netzbereiche 210 für sich genommen eine Versorgungssicherheit zumindest teilweise gewährleisten können.

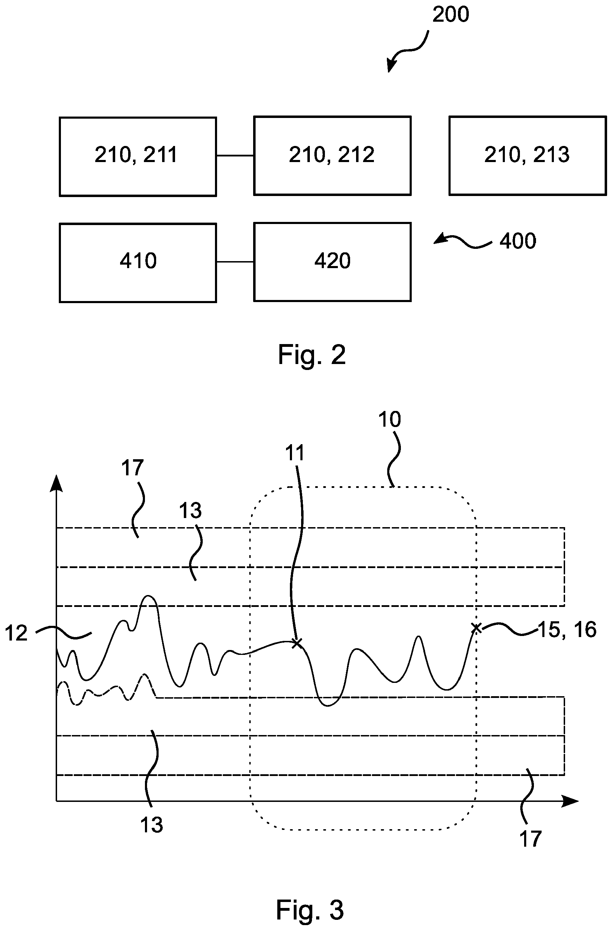

In Figur 1 dargestellt ist, dass ein Festlegen 150 eines späteren Zeitfensters vorgesehen sein, kann wobei das spätere Zeitfenster zumindest nach dem Zeitfenster 10 oder dem Zeitpunkt des Messens 130 liegt, wobei insbesondere das spätere Zeitfenster bei Wiederholung der Verfahrensschritte als Zeitfenster 10 ausgeführt ist. Das spätere Zeitfenster würde also in der Figur 3 rechts vom Zeitfenster 10 liegen. Anders ausgedrückt kann das Verfahren 100 als weiteren Schritt vorsehen, dass für eine Wiederholung des Ablaufes ein neues Zeitfenster geplant wird. Dadurch wird der Vorteil erreicht, dass das Verfahren 100 in einer Art Schleife ausführbar ist, sodass dauerhaft eine Bewertung des Zustandes des Netzbereiches 210 mit aktuellen Referenzwerden durchgeführt werden kann.

Ferner ist in der Figur 1 ein Schritt 111 dargestellt. Dieser entspricht einem Aufbereiten 111 des zumindest einen Referenzmesswertes 11 oder eines Messwertes 15, wobei insbesondere das Aufbereiten 111 zumindest eine Mittelwertbildung, eine Glättung, ein Filtern oder eine Fast Fourier Transformation umfasst. Durch die Aufbereitung 111 kann zum einen vermieden werden, dass Ausreißer die Bestimmung der Bereiche 12, 13 negativ beeinflussen und die Genauigkeit verschlechtern. Zum anderen kann durch die Aufbereitung 111, beispielsweise durch die Fast Fourier Transformation (FFT), eine Zusatzinformation ermittelt werden, wodurch die Aussagekraft der Bereiche 12, 13 erhöht werden kann.

Neben dem Verfahren 100 zur dezentralen Bewertung der Versorgungssicherheit eines Netzbereiches ist in der Figur 1 auch ein Verfahren 300 zum dezentralen Betrieb eines Netzbereiches 210 eines Stromnetzes 200, umfassend ein Verfahren 100 nach einem der Ansprüche 1 bis 12, wobei zumindest wenn die Versorgungssicherheit des Netzbereiches 210 als gefährdet bewertet 140 wird, als Reaktion auf die Bewertung 140 das Durchführen 310 zumindest einer Maßnahme vorgesehen ist, welche dazu ausgeführt ist, die Versorgungssicherheit des Netzbereiches 210 zu verbessern, gezeigt.

Der Schritt, dass zumindest wenn die Versorgungssicherheit des Netzbereiches 210 als gefährdet bewertet wird, als Reaktion auf die Bewertung das Durchführen 310 zumindest einer Maßnahme vorgesehen ist, welche dazu ausgeführt ist, die Versorgungssicherheit des Netzbereiches 210 zu verbessern, kann ebenfalls Teil des Verfahrens 100 nach einem der Ansprüche 1 bis 12 sein.

Maßnahmen zur Verbesserung der Versorgungssicherheit kann insbesondere die Vorbereitung auf ein Abschalten und/oder ein Abschalten von Verbrauchern und/oder Stromerzeugern sein. Ferner kann vorgesehen sein, dass eine Meldung, insbesondere an den Netzbetreiber, ausgegeben wird, damit im restlichen Stromnetz 200 Maßnahmen ergriffen werden können, um die Versorgungssicherheit zu gewährleisten.

Insgesamt wird so der dezentrale Betrieb eines Netzbereiches 210 und auch des Stromnetzes 200 insgesamt in Bezug auf die Versorgungssicherheit verbessert.

Damit bringt ein erfindungsgemäßes Verfahren 100 zum dezentralen Betrieb eines Netzbereiches 210 eines Stromnetzes 200 die gleichen Vorteile mit sich, wie sie ausführlich mit Bezug auf das erfindungsgemäße Verfahren 100 zur dezentralen Bewertung der Versorgungssicherheit eines Netzbereiches 210 eines Stromnetzes 200 beschrieben worden sind.

Die Figur 2 zeigt ein erfindungsgemäßes System 400 im Zusammenhang mit einem Stromnetz 200. Das System 400 ist insbesondere ausgeführt zur Durchführung eines Verfahrens 100 nach einem der Ansprüche 1 bis 12 und/oder eines Verfahrens 300 nach Anspruch 12, zur dezentralen Bewertung der Versorgungssicherheit eines Netzbereiches 210 eines Stromnetzes 200 und/oder zum dezentralen Betrieb eines Netzbereiches 210, aufweisend eine Messeinheit 410, welche dazu ausgeführt ist,
- zumindest einen Referenzmesswert 11 in einem Zeitfenster 10 an einem Netzbereich 210 zu erfassen 110, und
- einen aktuellen Messwert 15 am Netzbereich 210 zu messen 130, sowie eine Steuereinheit 420, welche dazu ausgeführt ist,
- zumindest einen Normalbereich 12 und einen Gefährdungsbereich 13 zu ermitteln 120, wobei der Normalbereich 12 und der Gefährdungsbereich 13 durch den zumindest einen Referenzmesswert 11 im Zeitfenster 10 zumindest teilweise bestimmt sind, und
- die Versorgungssicherheit des Netzbereiches 210 auf Basis des aktuellen Messwertes 15 gemäß des ermittelten Normalbereiches 12 und des Gefährdungsbereiches 13 als normal oder gefährdet zu bewerten 140,
wobei zumindest die Erfassung 110, das Ermitteln 120, das Messen 130 und die Bewertung 140 am Netzbereich 210 durchgeführt werden.

Damit bringt ein erfindungsgemäßes System 400 die gleichen Vorteile mit sich, wie sie ausführlich mit Bezug auf das erfindungsgemäße Verfahren 100 zur dezentralen Bewertung der Versorgungssicherheit eines Netzbereiches eines Stromnetzes und/oder dem erfindungsgemäßen Verfahren 300 zum dezentralen Betrieb eines Netzbereiches beschrieben worden sind.

Ebenfalls in der Figur 2 ist gezeigt, dass der Netzbereich 210 zumindest ausgeführt als ein Letztverbraucherzugangspunkt 211, ein Letztverbrauchernetz 212 oder ein Inselnetz 213 seien kann. Die genannten Netzbereiche 210 bieten den Vorteil, dass diese gegenüber einem Stromnetz 200 relativ klein und/oder autark von diesem ausgeführt seien können.

Im Zusammenhang mit der Figur 3 werden noch einige Aspekte in Bezug auf die Bereiche 12, 13, 17 erläutert. Auf der Abszissenachse ist die Zeit und auf der Ordinate der Messwert und/oder der Referenzmesswert und/oder der weitere Referenzmesswert aufgetragen. Es kann beispielsweise vorgesehen sein, dass der Gefährdungsbereich 13 einen unteren Gefährdungsbereich, welcher unterhalb des Normalbereiches 12 liegt, und einen oberen Gefährdungsbereich, welcher oberhalb des Normalbereiches 12 liegt, umfasst. Anders ausgedrückt kann der Normalbereich 12 eine obere und untere Schranke aufweisen, wobei der Gefährdungsbereich 13 außerhalb der beiden Schranken liegt. Dies bietet den Vorteil, dass bei einfachen Vergleichen, z. B. bei der Abweichung einer Spannung von einem oberen und/oder unteren Grenzwert, besonders einfach bestimmt werden kann, ob der Gefährdungsbereich 13 erreicht wurde.

Im unteren Gefährdungsbereich der Figur 3 ist zudem zu erkennen, dass dieser keinen festen Wert aufweist, sondern zu Beginn der Zeitachse schwankt. Dies soll darstellen, dass die Ermittlung der Bereiche 12, 13 auch rollierend erfolgen kann, d. h. bei jeder Aktualisierung des und/oder der Referenzmesswerte werden auch die Bereiche 12, 13 entsprechend angepasst.

Ferner kann das Ermitteln 120 einen kritischen Bereich 17 umfassen, der durch den zumindest einen Referenzmesswert 11 im Zeitfenster 10 zumindest teilweise bestimmt ist, wobei der kritische Bereich 17 ein größeres Gefährdungspotential aufweist als der Gefährdungsbereich 13. Mit anderen Worten kann vorgesehen sein, dass neben dem Normal- und Gefährdungsbereich 13 noch zumindest ein anderer Bereich 17 vorgesehen ist, der einer größeren Dringlichkeit entspricht. Es kann ferner auch vorgesehen sein, dass noch weitere Bereiche mit einer feineren Abstufung vorgesehen sind. Durch die Festlegung von mehr Bereichen wird die Flexibilität bei der Bewertung des Netzbereichs 210 erhöht, sodass feiner abgestimmte Maßnahmen getroffen oder vorbereitet werden können.

Die voranstehende Erläuterung der Ausführungsformen beschreibt die vorliegende Erfindung ausschließlich im Rahmen von Beispielen. Selbstverständlich können einzelne Merkmale der Ausführungsformen, sofern technisch sinnvoll, frei miteinander kombiniert werden, ohne den Rahmen der vorliegenden Erfindung zu verlassen.

### Bezugszeichenliste

- 10: Zeitfenster
- 11: Referenzmesswert
- 12: Normalbereich
- 13: Gefährdungsbereich
- 15: Messwert
- 16: weiterer Referenzmesswert
- 17: kritischer Bereich

- 100: Verfahren
- 110: Erfassen
- 111: Aufbereiten
- 120: Ermitteln
- 121: zukünftiges Ermitteln
- 130: Messen
- 140: Bewerten
- 150: Festlegen

- 200: Stromnetz
- 210: Netzbereich
- 211: Letztverbraucherzugangspunkt
- 212: Letztverbrauchernetz
- 213: Inselnetz

- 300: Verfahren
- 310: Durchführen

- 400: System
- 410: Messeinheit
- 420: Steuereinheit

## Patentansprüche

1. Verfahren (100) zur dezentralen Bewertung der Versorgungssicherheit eines Netzbereiches (210) eines Stromnetzes (200), umfassend:
- Erfassen (110) zumindest eines Referenzmesswertes (11) in einem Zeitfenster (10) an dem Netzbereich (210),
- Ermitteln (120) zumindest eines Normalbereiches (12) und eines Gefährdungsbereiches (13), wobei der Normalbereich (12) und der Gefährdungsbereich (13) durch den zumindest einen Referenzmesswert (11) im Zeitfenster (10) zumindest teilweise bestimmt sind,
- Messen (130) eines aktuellen Messwertes (15) am Netzbereich (210), und
- Bewerten (140) der Versorgungssicherheit des Netzbereiches (210) auf Basis des aktuellen Messwertes (15) gemäß des ermittelten Normalbereiches (12) und des Gefährdungsbereiches (13) als normal oder gefährdet,
wobei zumindest die Erfassung (110), das Ermitteln (120), das Messen (130) und die Bewertung (140) am Netzbereich (210) durchgeführt werden.

2. Verfahren (100) nach Anspruch 1,
**dadurch gekennzeichnet,**
**dass** der Netzbereich (210) zumindest ausgeführt ist als ein Letztverbraucherzugangspunkt (211), ein Letztverbrauchernetz (212) oder ein Inselnetz (213).

3. Verfahren (100) nach Anspruch 1 oder 2,
**dadurch gekennzeichnet,**
**dass** der aktuelle Messwert (15) als weiterer Referenzmesswert (16) dient, welcher bei einem zukünftigen Ermitteln (121) den Normalbereich (12) und den Gefährdungsbereich (13) zumindest teilweise bestimmt, und/oder
**dass** ein Festlegen (150) eines späteren Zeitfensters vorgesehen ist, wobei das spätere Zeitfenster zumindest nach dem Zeitfenster (10) oder dem Zeitpunkt des Messens (130) liegt, wobei insbesondere das spätere Zeitfenster bei Wiederholung der Verfahrensschritte als Zeitfenster (10) ausgeführt ist.

4. Verfahren (100) nach einem der vorhergehenden Ansprüche,
**dadurch gekennzeichnet,**
**dass** zumindest der Referenzmesswert (11) oder der aktuelle Messwert (15) an einer Phase oder an zwei Phasen oder an drei Phasen des Netzbereiches (210) erfolgt, wobei insbesondere zumindest der Referenzmesswert (11) oder der aktuelle Messwert (15) zumindest als eine Spannung, ein Strom, eine Leistung oder eine Frequenz ausgeführt ist.

5. Verfahren (100) nach Anspruch 4,
**dadurch gekennzeichnet,**
**dass** bei der Ermittlung (120) der Bereiche und/oder beim Bewerten (140) des Netzbereichs ein Vergleich der Messung (130) eines aktuellen Messwertes (15) und/oder der Erfassung (110) zumindest eines Referenzmesswertes (11) auf zumindest zwei Phasen einbezogen wird.

6. Verfahren (100) nach einem der vorhergehenden Ansprüche,
**dadurch gekennzeichnet,**
**dass** der Gefährdungsbereich (13) einen unteren Gefährdungsbereich, welcher unterhalb des Normalbereiches (12) liegt, und einen oberen Gefährdungsbereich, welcher oberhalb des Normalbereiches (12) liegt, umfasst, und/oder
**dass** das Ermitteln (120) einen kritischen Bereich (17) umfasst, der durch den zumindest einen Referenzmesswert (11) im Zeitfenster (10) zumindest teilweise bestimmt ist, wobei der kritische Bereich (17) ein größeres Gefährdungspotential aufweist als der Gefährdungsbereich (13).

7. Verfahren (100) nach einem der vorhergehenden Ansprüche,
**dadurch gekennzeichnet,**
**dass** bei dem Bewerten (140) der Versorgungssicherheit des Netzbereiches (210) neben dem aktuellen Messwert (15) zumindest eine weitere Information verarbeitet wird, welche für den Netzbereich (210) spezifisch und insbesondere vorgegeben ist.

8. Verfahren (100) nach Anspruch 7,
**dadurch gekennzeichnet,**
**dass** die weitere Information als eine Umgebungsinformation ausgeführt ist, welche insbesondere Messwerte für eine aktuelle Sonneneinstrahlung, eine Windstärke oder eine Außentemperatur umfasst.

9. Verfahren (100) nach einem der vorhergehenden Ansprüche,
**dadurch gekennzeichnet,**
**dass** das Zeitfenster (10) eine vorgegebene Größe hat, wobei die vorgegebene Größe insbesondere zumindest eine Minute, eine Stunde oder einen Tag beträgt, und/oder dass das Zeitfenster (10) einen festgelegten zeitlichen Abstand hat, welcher insbesondere zumindest größer oder gleich einer Minute, einer Stunde, oder einem Jahr ist.

10. Verfahren (100) nach einem der vorhergehenden Ansprüche,
**dadurch gekennzeichnet,**
**dass** ein Aufbereiten (111) des zumindest einen Referenzmesswertes (11) und/oder des Messwertes (15) vorgesehen ist, wobei insbesondere das Aufbereiten (111) zumindest eine Mittelwertbildung, eine Glättung, ein Filtern oder eine Fast Fourier Transformation umfasst.

11. Verfahren (100) nach einem der vorhergehenden Ansprüche,
**dadurch gekennzeichnet,**
**dass** in Ergänzung zum Referenzmesswert (11) Referenzumgebungsmesswerte, insbesondere eine Sonneneinstrahlung, eine Windstärke oder eine Außentemperatur, aufgenommen werden, wobei insbesondere die Referenzumgebungsmesswerte mit in die Ermittlung (120) des Normalbereiches (12) und des Gefährdungsbereiches (13) aufgenommen wird.

12. Verfahren (300) zum dezentralen Betrieb eines Netzbereiches (210) eines Stromnetzes (200), umfassend ein Verfahren (100) nach einem der vorhergehenden Ansprüche, wobei zumindest wenn die Versorgungssicherheit des Netzbereiches (210) als gefährdet bewertet (140) wird, als Reaktion auf die Bewertung (140) das Durchführen (310) zumindest einer Maßnahme vorgesehen ist, welche dazu ausgeführt ist, die Versorgungssicherheit des Netzbereiches (210) zu verbessern.

13. Verfahren (300) nach Anspruch 12,
**dadurch gekennzeichnet,**
**dass** die Maßnahme insbesondere eine Ausgabe einer Meldung, vorzugsweise an den Netzbetreiber, und/oder eine Vorbereitung auf ein Abschalten und/oder ein Anschalten von Verbrauchern und/oder Stromerzeugern umfasst.

14. System (400), insbesondere ausgeführt zur Durchführung eines Verfahrens (100) nach einem der Ansprüche 1 bis 11 und/oder eines Verfahrens (300) nach Anspruch 12 oder 13, zur dezentralen Bewertung der Versorgungssicherheit eines Netzbereiches (210) eines Stromnetzes (200) und/oder zum dezentralen Betrieb eines Netzbereiches (210), aufweisend eine Messeinheit (410), welche dazu ausgeführt ist,
- zumindest einen Referenzmesswert (11) in einem Zeitfenster (10) an einem Netzbereich (210) zu erfassen (110), und
- einen aktuellen Messwert (15) am Netzbereich (210) zu messen (130), sowie eine Steuereinheit (420), welche dazu ausgeführt ist,
- zumindest einen Normalbereich (12) und einen Gefährdungsbereich (13) zu ermitteln (120), wobei der Normalbereich (12) und der Gefährdungsbereich (13) durch den zumindest einen Referenzmesswert (11) im Zeitfenster (10) zumindest teilweise bestimmt sind, und
- die Versorgungssicherheit des Netzbereiches (210) auf Basis des aktuellen Messwertes (15) gemäß des ermittelten Normalbereiches (12) und des Gefährdungsbereiches (13) als normal oder gefährdet zu bewerten (140),
wobei zumindest die Erfassung (110), das Ermitteln (120), das Messen (130) und die Bewertung (140) am Netzbereich (210) durchgeführt werden.

15. Computerprogrammprodukt, umfassend Befehle, die bei der Ausführung des Programms durch einen Computer, insbesondere durch eine Steuereinheit (420) eines Systems (400) nach Anspruch 14, diesen veranlassen, ein Verfahren (100) nach einem der Ansprüche 1 bis 11 und/oder ein Verfahren (300) nach Anspruch 12 oder 13 auszuführen.
